# EUROPÄISCHE PATENTSCHRIFT

(11) **EP 2 949 028 B1**
(45) Veröffentlichungstag und Bekanntmachung des Hinweises auf die Patenterteilung: **24.10.2018**
(21) Anmeldenummer: 14704073.7
(22) Anmeldetag: 24.01.2014
(51) Int. Cl.: H02K 11/22, H02K 11/02, H05K 1/18, H05K 3/32, H02K 5/22, H05K 1/02, H02K 11/01, H02K 11/40, H02K 11/33, H05K 3/40

(54) **ROTIERENDE ELEKTRISCHE MASCHINE**
ROTARY ELECTRIC MACHINE
MACHINE ÉLECTRIQUE TOURNANTE

(30) Priorität: 26.01.2013 DE 102013001339
(43) Veröffentlichungstag der Anmeldung: 02.12.2015
(73) Patentinhaber: Brose Fahrzeugteile GmbH & Co. Kommanditgesellschaft, Würzburg, 97076 Würzburg (DE)
(72) Erfinder: BERKOUK, Maurad, F-29217 Le Conquet (FR); LABAT, Sebastian, 97523 Schwanfeld (DE); FOURNIER, Eric, F-72700 Etival Lès Le Mans (FR)
(74) Vertreter: FDST Patentanwälte
(86) Internationale Anmeldenummer: PCT/EP2014/000190
(87) Internationale Veröffentlichungsnummer: WO 2014/114463

(56) Entgegenhaltungen:
- EP-A2- 1 130 745
- WO-A2-2005/046020
- DE-A1- 3 726 839
- DE-A1- 19 518 215
- DE-A1- 19 652 652
- DE-A1- 19 858 627
- GB-A- 2 140 218
- GB-A- 2 445 775

## Beschreibung

Die Erfindung liegt auf dem Gebiet der Elektrotechnik und bezieht sich speziell auf rotierende elektrische Maschinen, beispielsweise Elektromotoren und Generatoren.

Elektromotoren werden in zunehmendem Maße in der Automobiltechnik, jedoch auch in anderen Technologiefeldern eingesetzt, wo zunehmend mehr elektrische Antriebsaggregate zur Erhöhung der Sicherheit oder des Komforts eingeführt werden. Oft werden als Elektromotoren so genannte bürstenlose Motoren eingesetzt, die besonders gut und effizient steuerbar sind. Derartige Motoren weisen einen Stator mit einer elektrischen Wicklung auf, die zur Erzeugung eines rotierenden magnetischen Feldes geeignet angesteuert wird, wobei sich in dem rotierenden elektrischen Feld ein durch dieses angetriebener Rotor bewegt.

Zur Ansteuerung einer derartigen Wicklung wird üblicherweise die Pulsweitenmodulation (PWM) eingesetzt, mittels deren Ansteuerspannungen mit Frequenzen im Kilohertz- bis Megahertzbereich geeignet erzeugt werden, um im Ergebnis in der Statorwicklung die rotierenden Felder zu erzeugen.

Sollen insbesondere akustische Probleme mit einem solchen Motor vermieden werden, so ist anzustreben, besonders nahe an das Ziel einer zu erzeugenden sinusförmigen Ansteuerspannung heranzukommen, wozu auch besonders hohe Schaltfrequenzen bei der Pulsweitenmodulation erforderlich sind. Solche besonderen Bedingungen der Ansteuerung erzeugen andererseits elektromagnetische Wellen, die über die Wicklung und andere Teile des Motors oder auch eines entsprechend angesteuerten Generators abgestrahlt werden.

Auf vielen Gebieten der Technik ist ein starkes Abstrahlen von elektromagnetischen Wellen durch eine elektrische Maschine nicht akzeptabel oder nicht wünschenswert. Daher müssen solche Maschinen sorgfältig entstört und/oder abgeschirmt werden.

Aus der DE 198 58 627 A1, der WO 2005/046020 A2, sowie der EP 1 130 745 A2 sind Elektromotoren mit einer Steuerelektronik und Abschirmungen bekannt.

Der Erfindung liegt die Aufgabe zugrunde, eine rotierende elektrische Maschine zu schaffen, die besonders gut und effizient elektrisch abgeschirmt ist, um die Abstrahlung elektromagnetischer Signale zu minimieren. Zudem soll die Maschine möglichst auch unempfindlich gegenüber Spannungsstößen bzw. Spannungsüberschlägen sein.
Die Aufgabe wird mit den Merkmalen der Erfindung gemäß Patentanspruch 1 gelöst. Vorteilhafte Ausgestaltungen und Weiterbildungen sin Gegenstand der Unteransprüche.
Dazu ist bei der rotierenden elektrischen Maschine zwischen einer elektronischen Ansteuereinrichtung und einer Wicklung der elektrischen Maschine eine elektrisch leitende, zwischen der Ansteuereinrichtung und der Wicklung angeordnete Schirmplatte vorgesehen. Die rotierende elektrische Maschine weist zudem eine Anschlusseinrichtung auf, die wenigstens ein Koppelelement zur elektrischen Verbindung der Ansteuereinrichtung mit einer oder mehreren elektrischen Leitungen und ein zur Verbindung mit einem elektrischen Massepotential vorgesehenes Masseelement aufweist. Gemäß der Erfindung ist die Schirmplatte elektrisch leitend mittels einer Blechzunge über einen ersten elektrischen Druckkontakt mit dem Masseelement verbunden.
Die elektronische Ansteuereinrichtung der elektrischen Maschine weist typischerweise Feldeffekttransistoren, IGBTs, Thyristoren oder ähnliche Halbleiterelemente bzw. Halbleiterschalter zur Erzeugung eines pulsweitenmodulierten Signals oder allgemein eines zur Ansteuerung der Wicklung der Maschine geeigneten elektrischen Signals auf. Zur Ansteuerung und Energieversorgung wird die Ansteuereinrichtung mittels einer Anschlusseinrichtung mit entsprechenden Aggregaten zur Energieversorgung und Steuerung verbunden. Die Anschlusseinrichtung weist beispielsweise ein Koppelelement in Form einer Steckverbindung auf. Zudem ist ein Masseelement vorgesehen, das entweder ebenfalls über einen Steckverbinder oder über eine fest installierte Masseleitung mit einem Massepotential verbunden sein kann. Das entsprechende Masseelement kann beispielsweise das Steckergehäuse oder ein entsprechender Pol einer Steckverbindung sein. Es kann auch vorgesehen sein, dass ein Rahmen, ein Traggestell oder ein Stützgerüst der elektrischen Maschine das Masseelement bildet.

Wichtig im Zusammenhang mit der Erfindung ist dabei, dass insbesondere die Elemente der Abschirmung der elektrischen Maschine auf möglichst kurzem Wege mit dem Masseelement verbunden sind. Zudem soll auch der Übergangswiderstand in der leitenden Verbindung zum Masseelement möglichst gering sein. Dies bewirkt außer einer zuverlässigen Abschirmung von Feldern und Wellen auch die leichte und schnelle Abführung von Überspannungen, die beispielsweise durch elektrische Überschläge auf Teile der Abschirmung gelangen können, beispielsweise wenn geladene Teilchen im Zuge eines Kühlluftstroms in Kontakt mit Teilen der elektrischen Maschine gelangen.

Eine erfindungsgemäß gestaltete Blechzunge kann die Schirmplatte, die einen Teil der Abschirmung der elektrischen Maschine darstellt, zuverlässig mit dem Masseelement leitend verbinden. Dabei ist die Druckkontakteinrichtung dauerhaft und zuverlässig herstellbar und gleicht Herstellungs- sowie Montagetoleranzen leicht aus.

Oft sind sowohl die Anschlusseinrichtung als auch elektronische Bauteile auf derselben Seite einer Leiterplatte montiert, die von der Schirmplatte abgewandt ist. In diesem Fall ist es sinnvoll und technisch vorteilhaft, wenn auf der der Schirmplatte abgewandten Seite der Anschlusseinrichtung oder einer Leiterplatte der Anschlusseinrichtung ein elektrischer Leiter, wie beispielsweise die erfindungsgemäße Blechzunge, direkt mit einem Masseelement verbunden bzw. kontaktiert ist und diese Blechzunge unmittelbar durch die Ebene der Leiterplatte hindurch zu der Schirmplatte geführt ist. Dadurch wird eine komplizierte und lange Leiterführung bei der elektrisch leitenden Verbindung zwischen der Schirmplatte und dem Masseelement vermieden.

In dem elektrischen Verbindungsweg zwischen der Schirmplatte und dem Masseelement können Biegungen und Krümmungen von Leitern sowie Leiterteile, die als Leiterbahnen auf einer Leiterplatte verlaufen, vermieden werden, was in vielen Fällen sinnvoll und vorteilhaft ist, um Leiterschleifen mit Impedanzen zu vermeiden. Außerdem ist eine Blechzunge leicht federelastisch ausführbar, so dass mit dieser ein elektrischer Druckkontakt besonders einfach herstellbar ist.
Die Schirmplatte ist üblicherweise durch eine Metallplatte gebildet, die wenigstens in Teilen, vorteilhaft im Wesentlichen oder sogar vollständig in unmittelbarer Nachbarschaft einer Leiterplatte der Ansteuereinrichtung verläuft. Die Schirmplatte kann in einem solchen Fall außer deren Schirmwirkung auch die Funktion einer Wärmesenke für die Ansteuerungseinrichtung haben. Die Schirmplatte kann zu diesem Zweck auch an einer oder mehreren Stellen mit der Leiterplatte der Ansteuereinrichtung zur Übertragung von Wärme mechanisch verbunden sein.
Vorteilhaft kann es vorgesehen sein, dass in demjenigen Bereich, in dem der erste elektrische Druckkontakt zwischen der Blechzunge und der Schirmplatte gebildet ist, diese eine Vertiefung, z. B. in Form einer Sicke bildet, so dass dort ein Abstand oder ein erhöhter Abstand zwischen der Schirmplatte und einer in der Ansteuereinrichtung vorgesehenen Leiterplatte gebildet ist. Die Schirmplatte kann zudem einen erhöhten Rand aufweisen, der eine in unmittelbarer Nachbarschaft der Schirmplatte befindliche Leiterplatte umgibt und dabei abschirmt und schützt.
Es kann auch beispielsweise zur Kontaktierung der Schirmplatte mit dem Masseelement ein federnder Reiter auf einem Randabschnitt der Schirmplatte aufgeklemmt sein, der eine Blechzunge aufweist, die federnd gegen eine Leiterbahn einer Leiterplatte der Ansteuereinrichtung oder direkt gegen das Masseelement gedrückt ist.

Erfindungsgemäß ist die Blechzunge mittels eines mit dieser durch einen Druckkontakt elektrisch kontaktierten Verbindungsleiters mit dem Masseelement leitend verbunden. Beispielsweise kann die Blechzunge federnd gegen einen Verbindungsleiter gedrückt sein, der erfindungsgemäß einen Abschnitt einer Leiterbahn der Ansteuereinrichtung bildet oder umfasst.
Zudem kann die Erfindung vorteilhaft dadurch ausgestaltet werden, dass die Ansteuereinrichtung eine Leiterplatte mit Leiterbahnen aufweist, und dass die Blechzunge die Ebene der Leiterplatte, insbesondere eine Ausnehmung in der Leiterplatte durchsetzt und in einer Klemmeinrichtung mechanisch gehalten sowie elektrisch mit dem Masseelement oder mit der Schirmplatte verbunden ist.
Die Klemmeinrichtung kann beispielsweise auf einer Seite der Leiterplatte liegen, die von der Schirmplatte abgewandt ist. Die Klemmeinrichtung kann an der Ansteuereinrichtung befestigt und von dieser getragen sein. Insbesondere kann die Klemmeinrichtung an der Leiterplatte befestigt sein. Die Klemmeinrichtung kann jedoch auch vollständig von dem Masseelement getragen und mit diesem steif verbunden sein.
Vorteilhaft weist die Klemmeinrichtung mehrere Elemente auf, wobei ein Element, insbesondere ein isolierendes Element, der Klemmeinrichtung vorteilhaft mit der Leiterplatte verbunden ist. Damit wird deutlich, dass eine leitende Verbindung zwischen der Klemmeinrichtung und der Blechzunge einerseits und der Leiterplatte vorgesehen sein kann, jedoch zur Kontaktierung der Schirmplatte mit dem Masseelement nicht in allen Ausführungsformen notwendig ist.
Es kann auch vorteilhaft vorgesehen sein, dass wenigstens ein Element der Klemmeinrichtung steif mit dem Masseelement verbunden ist. Damit kann die Klemmeinrichtung durch das Masseelement beispielsweise mittels eines Blechstreifens getragen und an diesem befestigt und gleichzeitig durch diese Verbindung auch elektrisch kontaktiert sein.
Es kann zudem vorteilhaft vorgesehen sein, dass die Blechzunge sich im Wesentlichen in einer Längsrichtung erstreckt und die Klemmeinrichtung wenigstens eine Führungsschiene aufweist, in der die Blechzunge in ihrer Längsrichtung verschiebbar geführt ist. Beispielsweise kann die Führungsschiene als elektrisch leitendes Element ausgebildet sein und zusätzlich zur mechanischen Führungsfunktion auch die Funktion der elektrischen Kontaktierung der Blechzunge erfüllen.

Vorteilhaft weist die Klemmeinrichtung als weiteres Element ein Gegenlager auf, durch das die Blechzunge gegen die Führungsschiene gepresst ist. Das Gegenlager kann beispielsweise als elektrisch isolierendes Bauteil ausgebildet und mit der Leiterplatte verbunden sein. Die Blechzunge kann dann zwischen dem Gegenlager und der Führungsschiene im Reibschluss gehalten und bei der Montage unter Aufbringung der notwendigen Kraft gegen die Schirmplatte gedrückt werden. Durch die Eigenelastizität der Blechzunge kann die Druckkontaktierung zwischen dieser und der Schirmplatte aufrecht erhalten werden.

Zudem kann jedoch auch eine Rastverbindung vorgesehen sein, die die Blechzunge in der Führungsschiene festlegt. Dabei kann die Rastverbindung zwischen der Blechzunge einerseits und dem Gegenlager andererseits vorgesehen sein, jedoch auch zwischen der Blechzunge und einer Ausnehmung oder Erhebung der Führungsschiene. Es kann auch eine ausbiegbare Rastlasche an der Blechzunge vorgesehen sein.

Zur Montage wird dann die Blechzunge in der Führungsschiene derart weit auf die Schirmplatte zu geschoben, dass diese die Schirmplatte kontaktiert und die Verrastung einrastet.

In dem Fall, in dem die elektrische Verbindung zwischen dem Masseelement und der Schirmplatte keinen Leiterabschnitt einbezieht, der als Leiterbahn auf einer Leiterplatte ausgebildet ist, wobei die Leiterführung gänzlich unabhängig von der Leiterplatte geführt und die Leiterplatte beweglich durch den Abschnitt des als Blechzunge ausgebildeten Verbindungsleiters durchsetzt ist, kann vorteilhaft vorgesehen sein, dass die Blechzunge durch ein zweites Druckkontaktstück mit einer Leiterbahn der Leiterplatte in einer Druckkontaktverbindung zusammenwirkt und diese über die Blechzunge mit dem Masseelement elektrisch verbindet.

Damit ist sichergestellt, dass die Verbindungsleitung zwischen dem Masseelement und der Schirmplatte in kürzest möglicher Form ausgebildet ist, und dass dieser Verbindungsleiter zusätzlich zur Verbindung eines Masseanschlusses der Leiterplatte mit dem Masseelement dient.

Die Blechzunge kann vorteilhaft auch wenigstens zwei Teile, einen vorderen und einen hinteren Blechstreifen aufweisen, die in Längsrichtung gegeneinander verschiebbar sind. Dabei kann durch die Verschiebung der Blechstreifen gegeneinander eine Rastlasche eines Blechstreifens zwischen einer ausgelenkten Rastposition und einer nicht ausgelenkten Position verschoben werden.

Vorteilhafterweise liegen zumindest Teile von Stator und Rotor des Motors auf Massepotential. Zweckmäßigerweise ist die rotierende elektrische Maschine bürstenlos. Mit anderen Worten ist der Stator nicht mittels Bürsten oder dergleichen mit dem Rotor elektrisch kontaktiert. Auf diese Weise ist eine elektromagnetische Störung weiter verringert. Insbesondere erfolgt der elektrische Kontakt zwischen dem Rotor und dem Stator, wenn Stator und Rotor zumindest teilweise auf Massepotential liegen, nicht mittels der Bürsten. Folglich ist erfolgt die hierfür erforderliche Kontaktierung über das Lager zwischen dem Rotor und dem Stator.

In einer Ausführungsform der Erfindung ist die Blechzunge mittels einer Rastzunge an der Leiterplatte festgelegt, die die Leiterplatte hintergreift, und die sich geeigneterweise auf der der Schirmplatte zugewandten Seite der Leiterplatte befindet. Insbesondere ist der Querschnitt der Blechzunge im Wesentlichen u-förmig, wobei innerhalb dieser Kontur beispielsweise ein Element einer Klemmvorrichtung angeordnet ist. Zweckmäßigerweise ist die Blechzunge an dieses Element geklemmt, was eine besonders einfache Befestigung der Blechzunge erlaubt. Alternativ oder in Kombination hierzu ist ein Freiende der Blechzunge in einen Schlitz der Klemmvorrichtung eingeführt und wird dort kraftschlüssig gehalten.

In einer weiteren Ausführungsform der Erfindung ist die Blechzunge an einem Freiende, das insbesondere dem Druckkontakt gegenüber liegt, unter Bildung zweier Schenkel eingeschnitten, die im Montagezustand beispielsweise im Wesentlichen plan auf der Leiterplatte aufliegen. Mit anderen Worten sind die beiden Schenkel abgewinkelt. Der elektrische Kontakt zwischen der Blechzunge, insbesondere deren Schenkel, und der Leiterplatte wird vorteilhafterweise mittels eines auf der Leiterplatte aufgebrachten Begrenzungsrings aus einem elektrisch leitenden Material realisiert. Der Begrenzungsring bildet zum Beispiel die Begrenzung eines in die Leiterplatte eingebrachten Lochs.

In noch einer weiteren Ausführungsform der Erfindung weist die Blechzunge eine Klammer auf, die zweckmäßigerweise an einem Freiende angeordnet ist, das insbesondere dem Druckkontakt gegenüber liegt. Die Klammer ist beispielsweise an dem Masseelement, dem Koppelelement oder anderen Bestandteilen der Anschlusseinrichtung angebunden, wobei das entsprechende Bauteil insbesondere zwischen zwei Klemmschenkeln der Klammer kraftschlüssig gehalten ist. Dies erlaubt eine vergleichsweise einfach und schnelle Montage der Blechzunge.

Die Erfindung bezieht sich außer auf eine rotierende elektrische Maschine gemäß den obigen Ausführungen mit einer Schirmplatte und mit einem Masseelement sowie mit einer Verbindung der Schirmplatte mit dem Masseelement mittels einer Blechzunge auch auf eine Ansteuerung für eine elektrische Maschine, mit einer Leiterplatte und mit einer die Ebene der Leiterplatte durchsetzende, in einer Klemmeinrichtung gehaltene und mit einem Massepotential verbundene elastische Blechzunge, die zur Herstellung eines elektrischen Druckkontaktes mit einer der Leiterplatte benachbarten elektrisch leitenden Schirmplatte eingerichtet ist.

Eine solche Ansteuereinrichtung ist üblicherweise zur Montage mit einer entsprechenden elektrischen Maschine geeignet, kann jedoch getrennt von dieser aufgebaut, vorbereitet und transportiert werden. Zudem ist auch die Verwendung einer solchen Ansteuereinrichtung für verschiedenartige elektrische Maschinen denkbar, wobei die Art der Ansteuerung durch entsprechende Ausgestaltung bzw. Justage und Initialisierung der Ansteuereinrichtung angepasst werden kann.

Nachfolgend werden Ausführungsbeispiele von elektrischen Maschinen anhand einer Zeichnung näher erläutert. Darin zeigen:
- Fig. 1:: einen Längsschnitt durch einen schematisch dargestellten Elektromotor, auf der linken Seite der Darstellung mit Außenrotor, auf der rechten Seite der Darstellung mit Innenrotor dargestellt,
- Fig. 2:: eine Blechzunge mit einer Führungsschiene zur Verbindung einer Schirmplatte mit einem Masseelement,
- Fig. 3:: eine dreidimensionale Ansicht einer Ansteuereinrichtung sowie eines Motorgehäuses,
- Fig. 4:: eine dreidimensionale Ansicht einer Ansteuereinrichtung mit einem Elektromotor bei teilweise weggelassenem Gehäuse,
- Fig. 5: eine Ansicht einer Ansteuereinrichtung für einen Elektromotor von der Bestückungsseite der Leiterplatte aus gesehen,
- Fig. 6: eine Blechzunge mit einer Führungsschiene in dreidimensionaler Darstellung,
- Fig. 7 u. 8:: weitere Darstellungen einer Blechzunge gemäß Fig. 6 aus anderen Ansichtsrichtungen,
- Fig. 9: eine Blechzunge wie in den Figuren 6 bis 8 dargestellt, ohne Führungsschiene,
- Fig. 10: eine andere Ausführungsform einer Blechzunge mit einer Führungsschiene,
- Fig. 11: eine Blechzunge wie in Fig. 10 dargestellt, ohne Führungsschiene,
- Fig. 12: eine Blechzunge wie in Fig. 11 dargestellt, in anderer Ansicht,
- Fig. 13: eine Blechzunge in einer Führungsschiene wie in Fig. 10 dargestellt, in anderer Ansicht,
- Fig. 14: eine Führungsschiene für eine Blechzunge entsprechend den Figuren 10 bis 13,
- Fig. 15: ein Brückenelement zur Verbindung eines Stators einer elektrischen Maschine mit einem Masseelement,
- Fig. 16: das Brückenelement aus Fig. 15 in anderer Ansicht,
- Fig. 17: in dreidimensionaler Ansicht eine Darstellung eines mäanderförmigen Federbleches,
- Fig. 18: eine weitere Ausführungsform der Blechzunge mit einer Führungsschiene,
- Fig. 19a,b: eine weitere Ausführungsform der Blechzunge ohne eine Führungsschiene, sowie
- Fig. 20-22: jeweils weitere Ausführungsformen der Blechzunge.

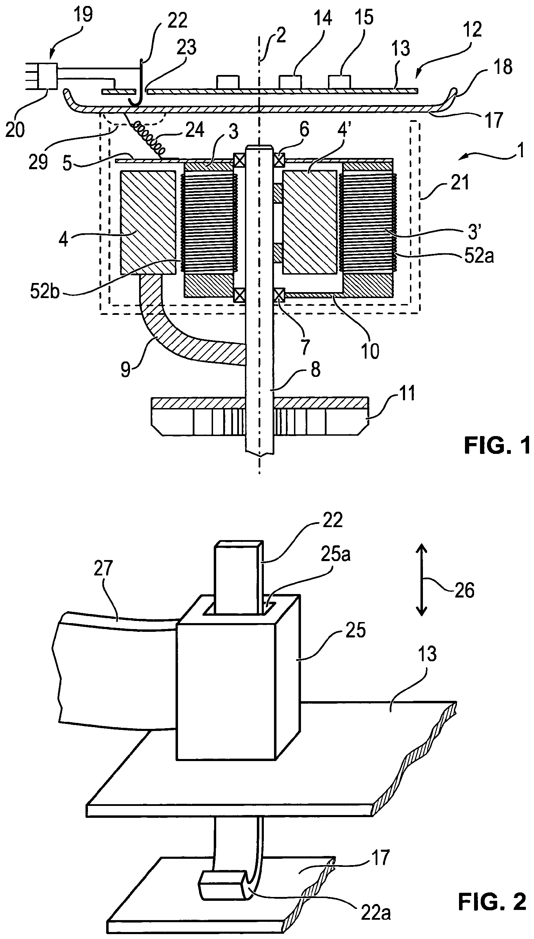

Fig. 1 zeigt im Überblick in einem Längsschnitt eine elektrische Maschine am Beispiel eines bürstenlosen Elektromotors 1.

Auf der linken und der rechten Seite der Mittellinie 2 sind unterschiedliche Konfigurationen dargestellt. Auf der linken Seite ist in einem Halbschnitt ein bürstenloser elektrischer Motor mit einem innenliegenden Stator 3 und einem Außenrotor 4 dargestellt. Der innenliegende Stator ist mit einem stirnseitigen Lagerschild 5 verbunden. Gegenüber dem Lagerschild ist mittels eines ersten Lagers 6 und eines zweiten Lagers 7 die jeweils im linken und rechten Halbschnitt gleich ausgebildet sein können, eine Welle 8 drehbar gelagert.

Bei der im linken Halbschnitt dargestellten Maschine ist der Außenrotor 4 mittels Stegen oder einer glockenartigen Einrichtung 9 mit der Welle 8 verbunden und durch diese getragen. Zudem kann der Außenrotor 4 noch am Lagerschild 5 mittels eines nicht dargestellten Wälzlagers gelagert sein.

Auf der rechten Seite des Schnittes der Fig. 1 ist ein Elektromotor mit einem Innenläufer dargestellt, so dass der Rotor 4' radial innerhalb des Stators 3' liegt. Der Stator 3' ist mit dem Lagerschild 5 fest verbunden ebenso wie beispielsweise mit einem weiteren Lagerschild 10.

Der Stator 3, 3' ist jeweils mit einer Wicklung 52a, 52b versehen, die einen oder mehrere Kerne umgibt und in nicht näher dargestellter Weise über Ansteuerleitungen mit einer Ansteuereinrichtung 12 verbunden ist

An den Lagerschilden 5, 10 ist mittels der Lager 6, 7 die Welle 8 drehbar gelagert. Mit der Welle 8 ist zudem der innen liegende Rotor 4' fest verbunden.

Beide Konstruktionen sind in der Technik an sich bekannt und hier nur der Vollständigkeit halber beide dargestellt, da bei beiden Ausführungsformen die Erfindung anwendbar ist.

In der Verlängerung der Welle 8 nach unten ist als Funktionselement, das von der Welle anzutreiben ist, das Flügelrad 11 eines Lüfters/Ventilators angedeutet.

In der Fig. 1 oberhalb von Stator und Rotor ist die Ansteuereinrichtung 12 gezeigt, die eine Leiterplatte 13 und darauf angeordnete elektronische Bauelemente 14, 15 aufweist. Zwischen der Ansteuereinrichtung 12, genauer der Leiterplatte 13, und dem Lagerschild 5 des Motors ist eine Schirmplatte 17 angeordnet, die wenigstens teilweise aus Metall besteht oder metallisiert ist und die einen aufwärts zur Leiterplatte hin umgebördelten Rand 18 aufweist. Die Schirmplatte 17 kann zudem als Wärmesenke für die Ansteuereinrichtung 12 dienen und mit der Leiterplatte 13 fest verbunden sein.

Die Ansteuereinrichtung 12 ist mit einer Anschlusseinrichtung 19 verbunden, die unter anderem ein Koppelelement zur elektrischen Verbindung mit Leitungen in Form eines Teils eines Steckverbinders 20 aufweist. Zudem ist das Gehäuse des Steckverbinders 20 in dem gezeigten Beispiel mit Massepotential verbunden und kann ein Masseelement bilden.

In der Fig. 1 ist zudem durch die gestrichelte Doppelkontur 21 die Ausformung und Wirkung einer elektrischen Abschirmung des Motors dargestellt. Die Doppelkontur 21 bildet eine glockenartige Abdeckung, die auf ihrer offenen Seite zusätzlich durch die Schirmplatte 17 abgeschlossen ist, so dass die elektromagnetisch strahlenden Teile von Stator und Rotor nach außen hin keine oder möglichst wenig elektromagnetische Strahlung abgeben.

Außerdem ist durch die Schirmplatte 17 speziell auch die Ansteuereinrichtung 12 besonders gut gegenüber der Wicklung des Motors abgeschirmt.

Die Doppelkontur 21 kann beispielsweise als Gesamtkontur durch die geerdeten Teile von Stator und Rotor des Motors gebildet sein, sie kann jedoch auch in einem zusätzlichen metallisierten Bauteil bestehen, das diese genannten Bauteile des Motors umgibt. Es kann sich dabei beispielsweise auch um ein Motorgehäuse handeln.

Grundsätzlich muss die Doppelkontur 21 jedoch nicht notwendigerweise ein konkretes Bauteil bezeichnen, sondern kann lediglich die durch die vorliegende Erfindung gewährleistete elektromagnetische Schirmfunktion symbolisieren.

Um die hierfür vorgesehenen Teile von Stator und Rotor des Motors sowie die Schirmplatte 17 effektiv mit dem Massepotential zu verbinden, sind gemäß der vorliegenden Erfindung verschiedene Maßnahmen vorgesehen.

Einerseits soll mit möglichst geringem elektrischen Widerstand und auf möglichst kurzem Weg die Schirmplatte 17 mit einem auf Massepotential liegenden Masseelement der Anschlusseinrichtung verbunden werden. Hierzu ist eine in der Fig. 1 nur schematisch angedeutete Blechzunge 22 vorgesehen, die mit der Anschlusseinrichtung auf kurzem Wege verbunden ist und die ihrerseits mit der Schirmplatte 17 einen elektrischen Druckkontakt herstellt. Die Blechzunge 22 durchsetzt dabei die Ebene der Leiterplatte 13. Hierzu weist die Leiterplatte 13 eine durchgehende Öffnung 23 auf.

Die Führung der Blechzunge wird konkreter weiter unten anhand von Ausführungsbeispielen im Einzelnen dargestellt.

Um die Abschirmfunktion der auf Massepotential liegenden Teile von Stator und Rotor des Motors zu realisieren, ist eine möglichst zuverlässige und kurze Verbindung des Lagerschilds 5 mit der Schirmplatte 17 vorgesehen. Diese Verbindung weist eine Kontaktbrücke 24 auf, die einerseits elektrisch leitend zuverlässig und effektiv mit der Schirmplatte 17 einerseits und dem Lagerschild 5 andererseits kontaktiert ist und die andererseits genügend Flexibilität aufweist, um Fertigungstoleranzen bei der Montage des Motors einerseits sowie Bewegungen im Betrieb zwischen der Schirmplatte 17 beziehungsweise der Ansteuereinrichtung 12 und Stator und Rotor des Motors andererseits auszugleichen.

Die Gestaltung der Kontaktbrücke 24 wird ebenfalls weiter unten anhand von konkreten Ausführungsbeispielen genauer erläutert.

Fig. 2 zeigt in einer dreidimensionalen Ansicht die Leiterplatte 13 sowie die diese durchsetzende Blechzunge 22, die unterhalb der Leiterplatte 13 die Schirmplatte 17 mittels eines Druckkontaktes kontaktiert. Die Leiterplatte 13 und die Schirmplatte 17 sind dabei nur ausschnittsweise dargestellt.

Die Blechzunge 22 ist als flacher, elastisch biegsamer Blechkörper dargestellt, der an seinem der Schirmplatte 17 zugewandten Ende ein bogenförmig gestaltetes Druckkontaktstück 22a aufweist. Dieses ist elastisch verformbar, so dass mittels des Druckkontaktstücks 22a durch den Ausgleich von Toleranzen ein dauerhafter und sicherer Druckkontakt zur Schirmplatte 17 mit einer elastischen Anpresskraft durch elastische Verformung der Blechzunge hergestellt werden kann.

Die Blechzunge 22 ist vorteilhaft in einer Klemmeinrichtung 25 einerseits mechanisch gehalten und andererseits elektrisch kontaktiert. Die Klemmeinrichtung 25 besteht deshalb vorteilhaft wenigstens teilweise aus einem gut leitenden Metall.

Innerhalb der Klemmeinrichtung 25 ist die Blechzunge entweder kraftschlüssig, d.h. durch Reibung oder mittels einer Verrastung gehalten und insbesondere in Richtung senkrecht zur Oberfläche der Leiterplatte 13, wie durch den Doppelpfeil 26 angedeutet, fixiert.

Die Klemmeinrichtung 25 ist mittels einer Anschlussfahne 27 mit einem Masseelement der Anschlusseinrichtung 19 verbunden. Beispielsweise kann die Kontaktfahne als steifes Metallblech ausgebildet sein, das mit der Klemmeinrichtung 25 einstückig oder durch eine Kleb-, Löt- oder Schweißverbindung verbunden ist und das in einer in der Fig. 2 nicht näher dargestellten Weise steif mit dem auf Massepotential liegenden Gehäuse des Kopplungselementes 20, d.h. beispielsweise einer Steckerbuchse verbunden ist.

Die Klemmeinrichtung 25 kann auf der Leiterplatte fixiert sein, sie kann jedoch auch gegenüber dieser beweglich und mit dieser nicht verbunden und durch die Kontaktfahne 27 ausschließlich gehalten sein.

In dem in der Klemmeinrichtung 25 gebildeten Führungskanal 25a für die Blechzunge 22, der eine Führungsschiene für die Blechzunge 22 darstellt, kann die Blechzunge durch ein beigefügtes metallisches oder Kunststoff-Teil in lateraler Richtung senkrecht zur Richtung des Doppelpfeils 26 kraftschlüssig festgeklemmt sein. Die Blechzunge 22 kann auch einen gebogenen Abschnitt aufweisen, der innerhalb des Führungskanals 25a einklemmbar ist. Außerdem ist es auch möglich, innerhalb des Führungskanals 25a eine Verrastung zwischen der Blechzunge 22 und einem metallischen oder Kunststoff-Teil der Klemmeinrichtung 25 vorzusehen.

Dabei kann beispielsweise auch ein Kunststoff-Teil der Rastvorrichtung mit der Leiterplatte 13 oder mit Teilen der Klemmeinrichtung fest verbunden sein.

Im Zusammenhang mit der Durchführung der Blechzunge 22 durch die Öffnung der Leiterplatte 13 kann auch in der Ebene der Leiterplatte 13 ein dort vorgesehener Masseleiter in Form einer Leiterbahn mit der Blechzunge 22 kontaktiert sein. Einerseits kann auf diese Weise eine Leiterbahn der Leiterplatte mittels der Blechzunge 22 mit dem Masseelement verbunden sein, es kann jedoch auch vorgesehen sein, dass das Masseelement anderweitig auf kurzem Wege mit der Leiterbahn der Leiterplatte verbunden ist und die Blechzunge 22 ausschließlich über die Leiterbahn der Leiterplatte 13 mit dem Masseelement verbunden ist. In diesem Fall dient die Blechzunge 22 zur Herstellung einer leitenden Verbindung zwischen der auf Massepotential liegenden Leiterbahn der Leiterplatte 13 und der Schirmplatte 17.

Wenn die Klemmeinrichtung 25 fest mit der Leiterplatte 13 verbunden ist, kann die Kontaktfahne 27 auch durch einen flexiblen Leiter realisiert sein.

Die Öffnung 23 in der Leiterplatte, durch die hindurch sich die Blechzunge 22 erstreckt, kann auch beispielsweise am Rand der Leiterplatte 13 liegen und zum Rand hin offen sein, also lediglich eine seitliche Ausnehmung der Leiterplatte 13 darstellen.

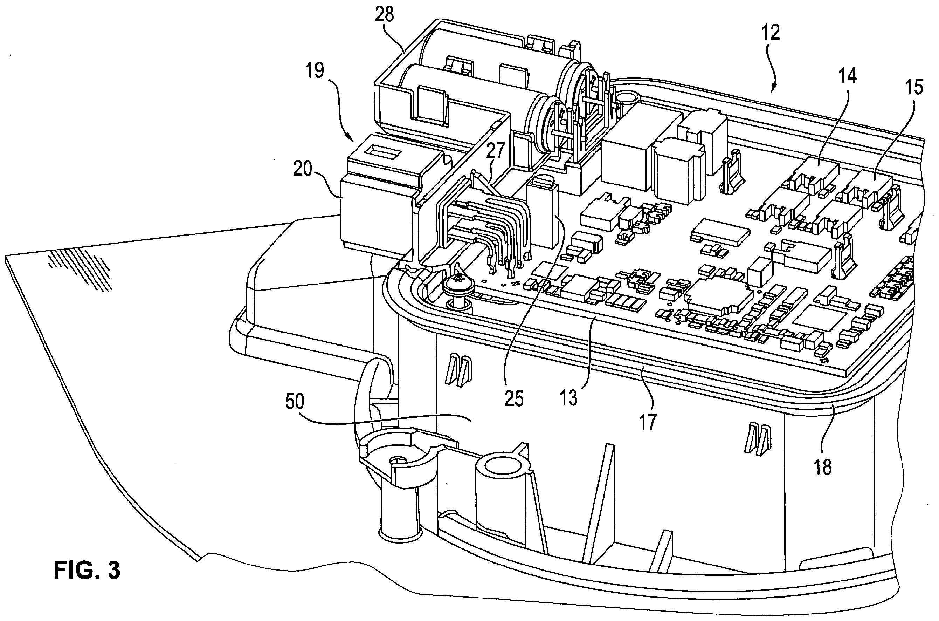

Die Fig. 3 zeigt in einer dreidimensionalen Ansicht einen Elektromotor mit einem Gehäuse 50 sowie einer Ansteuereinrichtung 12 mit einer Leiterplatte 13 und einer in der Figur unterhalb der Leiterplatte 13 angeordneten Schirmplatte 17 mit umgebördeltem Rand 18. Die Schirmplatte 17 kann beispielsweise mit der Leiterplatte 13 in engem Kontakt stehen, so dass die Schirmplatte 17 gleichzeitig als Wärmesenke für die elektronischen Bauteile der Leiterplatte 13 dienen kann. Es können Wärmebrücken zwischen der Leiterplatte 13 und der Schirmplatte 17 vorgesehen sein und die beiden Elemente können auch miteinander direkt verklebt sein.

Die Schirmplatte 17 ist mit dem Gehäuse 50 in nicht weiter dargestellter Weise verbunden. Es sind in der Figur auf der Oberseite der Leiterplatte 13 verschiedene elektronische Bauelemente 14, 15 sichtbar, unter denen beispielsweise Thyristoren, IGBTs oder ähnliche Halbleiterbauelemente sind, die es erlauben, die Wicklung des Motors mittels pulsweitenmodulierter Signale hochfrequent anzusteuern.

In der Fig. 3 ist ebenfalls eine Anschlusseinrichtung 19 erkennbar mit einem Koppelelement 20 in Form eines Teils einer Steckerverbindung, wobei das Koppelelement 20 als Steckergehäuse mit in seinem Inneren liegenden Kontaktpins ausgebildet ist. Das Steckergehäuse 20 ist beispielsweise direkt mit dem Massepotential verbunden oder es enthält einen Kontaktpin, der seinerseits mit dem Massepotential verbunden wird.

In der Fig. 3 ist auf der der bestückten Seite der Leiterplatte 13 der Anschlusseinrichtung 19 eine Kontaktfahne 27 dargestellt, die als ein mit einem Rahmen 28 der Anschlusseinrichtung 19 fest verbundenes, beispielsweise verschweißtes Blech ausgeführt ist. Der Rahmen 28 der Anschlusseinrichtung kann in diesem Fall ein Masseelement bilden.

Zudem ist in der Fig. 3 die Klemmeinrichtung 25 erkennbar, aus der oben eine Blechzunge herausragt.

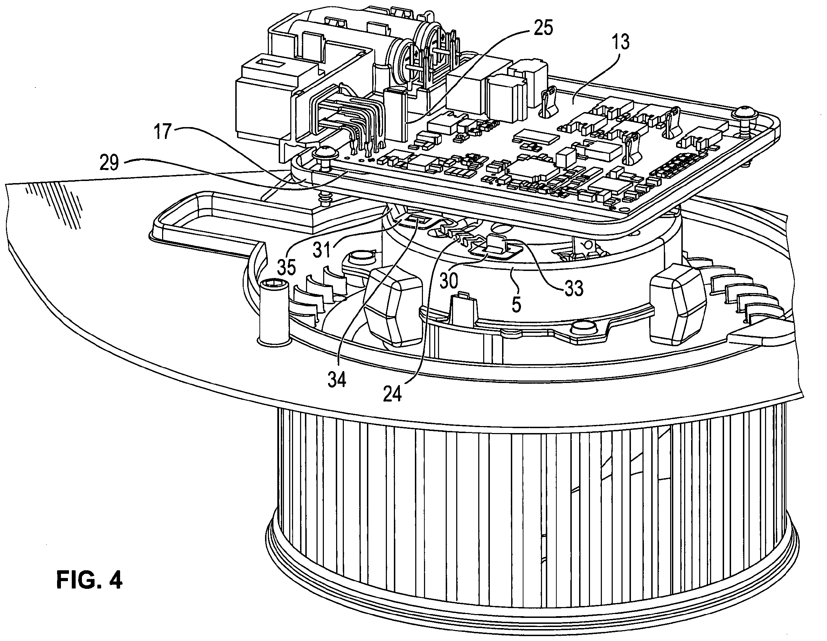

Die Fig. 4 zeigt aus einem etwas veränderten Blickwinkel die Konstruktion der Fig. 3, wobei darauf hingewiesen werden soll, dass die Schirmplatte 17 im Bereich der Ausnehmung in der Leiterplatte 13, durch die die Blechzunge im Bereich der Klemmeinrichtung 25 hindurch ragt, eine Vertiefung 29 aufweist, so dass in diesem Bereich der Abstand zwischen der Schirmplatte 17 und der Leiterplatte 13 vergrößert und Platz für eine Druckkontaktvorrichtung bzw. für ein Druckkontaktstück 22a der Blechzunge 22 gebildet ist.

Die Vertiefung ist in der Fig. 1 durch eine gestrichelte Linie im Bereich der Blechzunge unterhalb der Schirmplatte 17 in einem Schnitt dargestellt.

Unterhalb der Schirmplatte 17 ist in der Fig. 4 auch die Verbindung der Schirmplatte mit einem Lagerschild 5 des Motors in Form der Kontaktbrücke 24 dargestellt.

Die Kontaktbrücke weist einen ersten Befestigungsabschnitt 30 sowie einen zweiten Befestigungsabschnitt 31 und zwischen diesen ein Brückenelement 32 auf. Dieses wird weiter unten detailliert erläutert.

Die Befestigungsabschnitte 30, 31 der Kontaktbrücke 24 sind auf Kontaktdorne 33, 34 aufgesteckt, die entweder nur der Befestigung oder der Befestigung und der elektrischen Kontaktierung der Kontaktbrücke dienen. In der Fig. 4 ist zudem zu erkennen, dass die Kontaktbrücke 24 auf der dem ersten Befestigungsabschnitt 30 abgewandten Seite des zweiten Befestigungsabschnittes 31 einen federnden Kontaktarm 35 aufweist, der in Richtung zur Unterseite der Schirmplatte 17 hin ausgerichtet ist und diese kontaktiert.

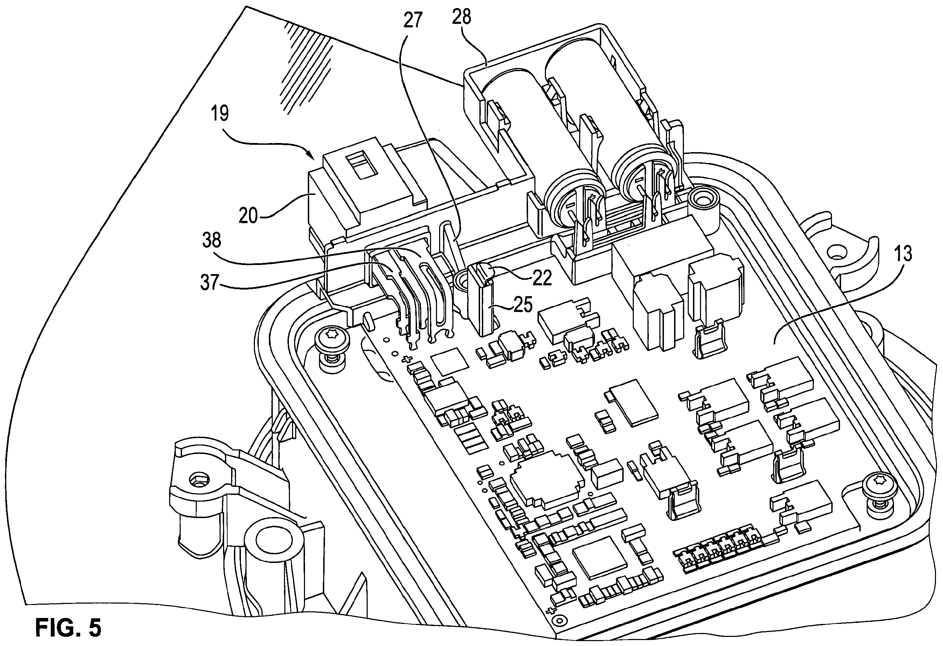

Die Fig. 5 zeigt in einer weiteren dreidimensionalen Ansicht die Oberseite des bereits in den Fig. 3 und 4 dargestellten Elektromotors, wobei besonders gut die Klemmeinrichtung 25 mit der Blechzunge 22 und der Kontaktfahne 27 zu erkennen ist. Zwischen der Kontaktfahne 27 und der Klemmeinrichtung 25 ist ein hohlzylindrisches metallisches Kontaktelement 36 eingefügt, das die Kontaktfahne 27 mit der Klemmeinrichtung 25 verbindet. Zudem ist erkennbar, dass die Kontaktpins des Koppelelementes 20 auf der Seite der Leiterplatte 13 über Anschlussleiter 37, 38 jeweils mit Leiterbahnen der Leiterplatte 13 verbunden sind. Jedoch ist bei dieser Ausgestaltung kein auf Massepotential liegender Anschlussleiter der Anschlusseinrichtung 19 direkt mit einer Leiterbahn der Leiterplatte 13 verbunden, so dass die mit dem Massepotential zu verbindenden Teile der Ansteuereinrichtung ausschließlich über die Kontaktfahne 27 bzw. die Blechzunge 22 mit dem Masseelement/Rahmen 28 verbunden sind.

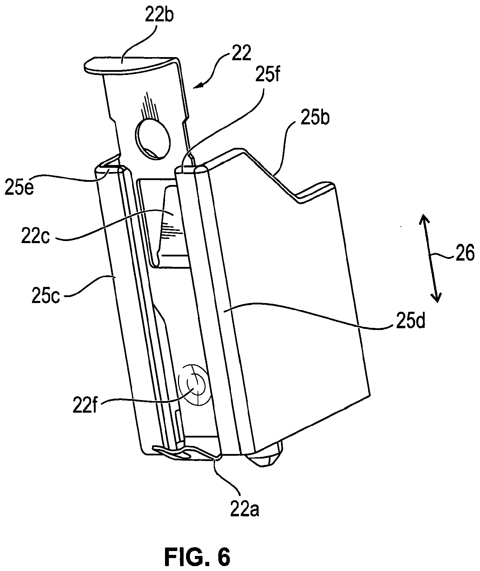

Die Fig. 6 bis 9, die in der Folge erläutert werden, zeigen verschiedene Ansichten verschiedener, leicht variierter Klemmeinrichtungen die im Rahmen der Erfindung eingesetzt werden können.

Fig. 6 zeigt in diesem Zusammenhang eine Führungsschiene 25b die zwei Seitenwangen 25c und 25d aufweist, zwischen denen die Blechzunge 22 in Richtung des Doppelpfeils 26 verschiebbar ist. Die Seitenwangen 25c, 25d weisen jeweils Abschlusswinkel 25e, 25f auf, die die Stirnseite der Blechzunge 22 teilweise abdecken und eine Führungsfläche für die Blechzunge 22 bilden.

Die Blechzunge 22 weist an ihrem oberen Ende ein Flachstück 22b auf, das hier als rechtwinklig abgewinkeltes Ende der Blechzunge ausgeführt ist und das beispielsweise der Manipulation der Blechzunge 22, d.h. konkret dem Einschieben in die Klemmeinrichtung 25 dienen kann.

Am unteren, dem Flachstück entgegengesetzten Ende der Blechzunge 22 ist das Druckkontaktstück 22a in Form eines ebenfalls umgebogenen Endes mit einer eingeprägten Sicke 22f erkennbar.

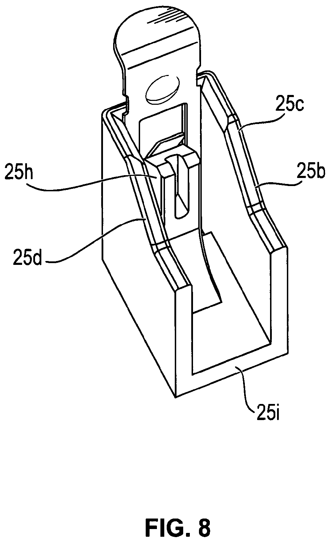

In ihrem Verlauf weist die Blechzunge eine Rastnase 22c auf, die als freigestanztes Blechzungenteil ausgebildet ist, das in der Darstellung der Fig. 6 in die Zeichenebene hinein ausgebogen ist. Beim Einschieben der Blechzunge 22 in die Klemmeinrichtung 25 kann diese Rastnase 22c, die eine freigestanzte Blechlasche sein kann, hinter einem Vorsprung eines Teils der Klemmeinrichtung 25 verrasten, wodurch die Blechzunge 22 vor einem Herausschieben aus der Klemmeinrichtung 25 bewahrt ist. Dies wird weiter unten im Zusammenhang mit der Fig. 8 näher erläutert.

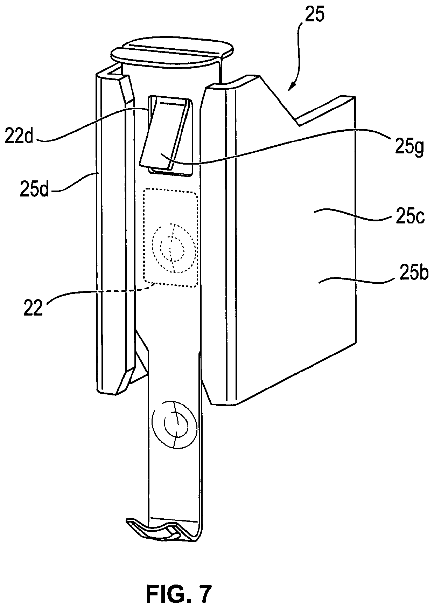

In der Fig. 7 ist eine Anordnung gezeigt, bei der die Blechzunge 22 eine Rastöffnung 22b aufweist, die beim Einschieben der Blechzunge in die Klemmeinrichtung 25 mit einer vorragenden Nase 25g der Klemmeinrichtung zur Verrastung zusammenwirkt.

Die Nase 25g kann beispielsweise ein Teil eines in der Fig. 7 nicht erkennbaren Bauteils sein, das zwischen den beiden Wangen 25c, 25d fixiert ist und das beispielsweise aus Metall oder Kunststoff bestehen kann.

Die Fig. 8 zeigt von der offenen Seite der Klemmeinrichtung 25b her den Zwischenraum zwischen den Seitenwangen 25c und 25d, wo das Bauteil 25h angeordnet ist, welches eine Rastnase aufweist und aus einem Metall oder Kunststoff bestehen kann. Das Bauteil 25h kann beispielsweise auf dem Boden 25i der Klemmeinrichtung 25, der zwischen den Seitenwangen 25c und 25 d verläuft, befestigt sein. Es ist ein freigestanztes Blechlaschenteil der Blechzunge dargestellt, dass mit der Rastnase verrasten kann.

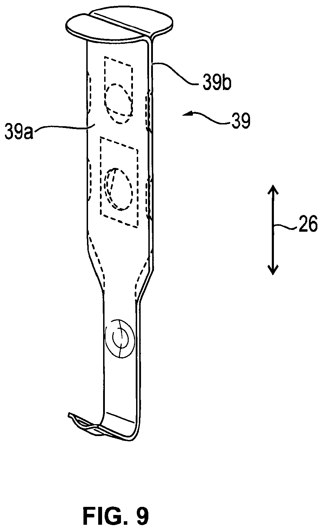

Die Figur 9 zeigt eine Blechzunge 39, die einen vorderen Blechstreifen 39a und einen mit diesem teilweise deckungsgleichen hinteren Blechstreifen 39b aufweist, die aneinander anliegen und gegeneinander in ihrer Längsrichtung (Doppelpfeil 26) verschiebbar sind. Durch die Verschiebung der Blechsteifen gegeneinander kann beispielsweise eine Blechlasche in einem der Blechstreifen, die als Rastnase wirkt, zur Entriegelung von einer Rastnase der Klemmeinrichtung verformt werden. Dazu weist beispielsweise der hintere Blechstreifen 39b eine Öffnung auf, die von einer Blechlasche des vorderen Blechstreifens zur Verrastung an einer Rastnase durchsetzt werden kann. Durch Verschiebung des hinteren Blechstreifens gegenüber dem vorderen Blechstreifen wird die Öffnung im hinteren Blechstreifen gegenüber der Blechlasche des vorderen Blechstreifens verschoben und zurückgebogen.

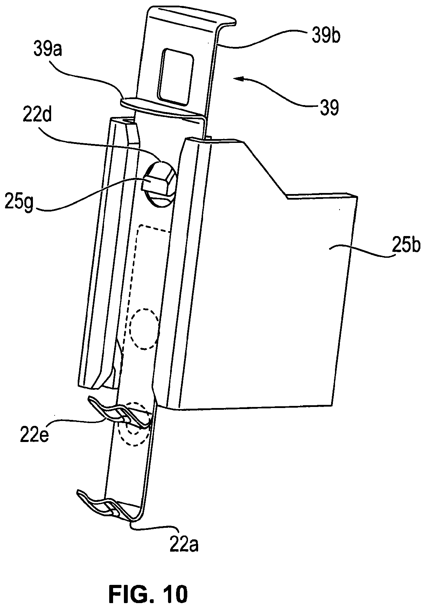

Die Figur 10 zeigt eine Klemmeinrichtung 25 mit einer Führungsschiene 25b sowie einer Blechzunge 39, die wie anhand der Figur 9 beschrieben aufgebaut ist. Der vordere und hintere Blechstreifen 39a, 39b sind derart zueinander verschoben, dass eine Verrastung mit der Rastnase 25g der Klemmeinrichtung stattfinden kann. Diese ragt durch eine Öffnung 22d in der Blechzunge.

Es ist zudem dargestellt, dass ein Druckkontaktstück 22a nach unten durch die nicht dargestellte Öffnung in der Leiterplatte hindurch und bis auf die Schirmplatte ragt. Es ist ein zweites Druckkontaktstück 22e dargestellt, das der Kontaktierung der Blechzunge 39 mit der Leiterplatte 13 bzw. einer dort vorgesehenen Leiterbahn mittels einer in dem Kontaktstück 22e vorgesehen Sicke dient. Die beiden Druckkontaktstücke 22a, 22e können an jeweils verschiedenen Blechstreifen/-Teilen 39a/39b der Blechzunge 39 oder gemeinsam an demselben Blechstreifen/Teilen vorgesehen sein.

Durch Verschieben des Teils 39b der Blechzunge 39 gegenüber dem Teil 39a kann die Verrastung der Nase 25g in der Rastöffnung 22d aufgehoben werden.

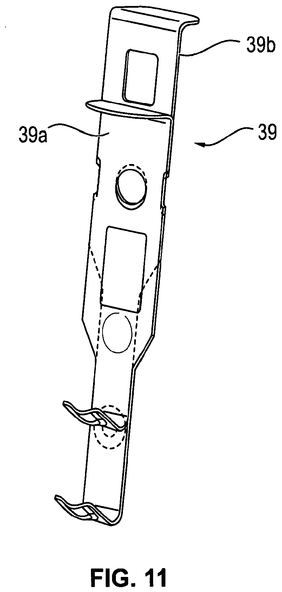

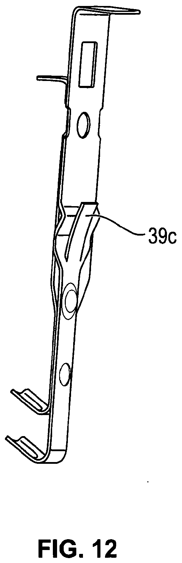

Die Fig. 11 zeigt die Blechzunge 39 mit dem vorderen Blechstreifen 39a und dem hinteren Blechstreifen 39b in voller Ansicht von einer ersten Seite, während die Fig. 12 dieselbe Konstellation aus der Fig. 11 von der entgegengesetzten Seite mit der Rastnase 39c darstellt.

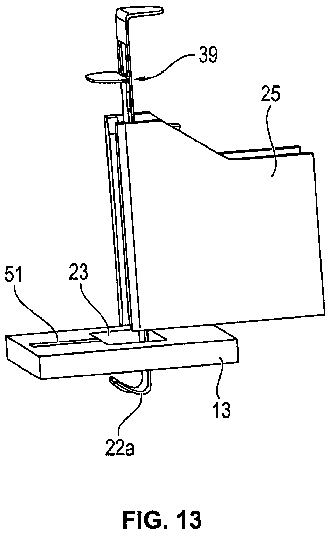

Die Fig. 13 zeigt die Klemmeinrichtung 25 mit der Blechzunge 39 die durch die Öffnung 23 in der Leiterplatte 13 hindurch ragt sowie das unterhalb der Leiterplatte 13 mit der Schirmplatte 17 zu kontaktierende Druckkontaktstück 22a.

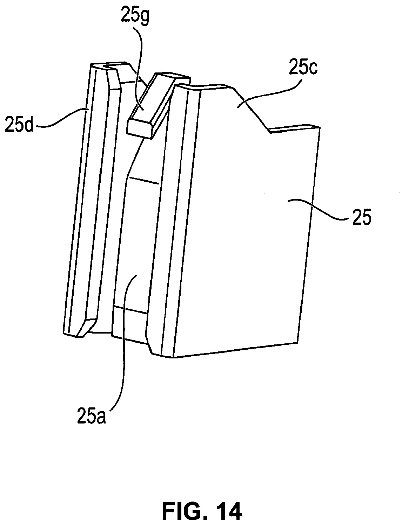

In der Fig. 14 ist die Klemmeinrichtung 25 dargestellt mit den beiden Seitenwangen 25c, 25d und einem zwischen diesen vorgesehenen Bauteil 25h, das die Nase 25g trägt. Die Nase 25g kann beispielsweise elastisch verformbar und durch eine Druckkraft aus der Bewegungsbahn der Blechzunge in der Klemmeinrichtung 25 entfernbar sein.

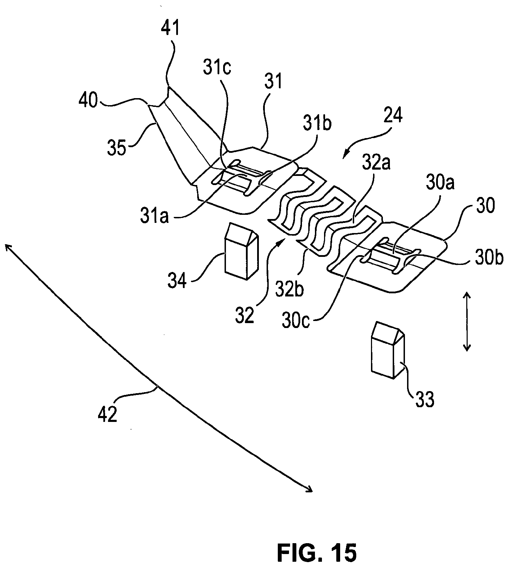

Die Fig. 15 zeigt in dreidimensionaler Ansicht eine Kontaktbrücke 24 mit einem ersten Befestigungsabschnitt 30 und einem zweiten Befestigungsabschnitt 31 sowie einem zwischen diesen angeordneten Brückenelement 32. Sowohl die Befestigungsabschnitte 30, 31 als auch das Brückenelement 32 und ein an dem Befestigungsabschnitt 31 anschließender Kontaktarm 35 sind vorteilhaft einstückig aus einem einzigen Federblech hergestellt, beispielsweise durch Stanzen oder Laserschneiden eines ebenen Federbleches.

Die Befestigungsabschnitte 30, 31 sind jeweils als flächenhafte ebene Abschnitte ausgebildet und weisen jeweils eine durchgehende Klemmöffnung 30a, 31a auf, die jeweils in dem Ausführungsbeispiel als gerader Klemmschlitz ausgebildet ist. An beiden Enden der Klemmschlitze 30a, 31a sind jeweils Trennschlitze 30b, 30c sowie 31b, 31c angeordnet, die jeweils quer, insbesondere senkrecht zu den Klemmschlitzen 30a, 31a verlaufen. Durch die Trennschlitze 30b, 30c, 31b, 31c sind jeweils Randstreifen in den Befestigungsabschnitten 30, 31 gebildet, die parallel neben den jeweiligen Klemmschlitzen verlaufen und aus der Ebene der Befestigungsabschnitte herausgebogen werden können.

Die Kontaktbrücke 24 kann derart auf Klemmdorne 33, 34 aufgesetzt werden, dass diese die Klemmschlitze 30a, 31a unter Aufbiegen der Randbereiche durchsetzen und dort verklemmt werden. Durch die spezielle Gestaltung der Randbereiche werden diese in den Klemmdornen 33, 34 aktiv verhakt, was zu einer besonders großen Stabilität gegenüber Abziehen der Kontaktbrücke 24 von den Klemmdornen führt.

Zwischen den Befestigungsabschnitten 30, 31 ist das Brückenelement 32 vorgesehen, das im Wesentlichen als mäanderförmiger ebener Blechleiter ausgebildet ist, um das Brückenelement möglichst gegenüber allseitigen Bewegungen der Befestigungsabschnitte 30, 31 flexibel zu machen.

Der einzelnen Leiterabschnitte 32a, 32b der mäanderförmigen Leiterführung sind in sich gebogen ausgeführt, um eine möglichst hohe Flexibilität zu erreichen.

An dem zweiten Befestigungsabschnitt 31 schließt sich ein Kontaktarm 35 einstückig an, der an seinem freien Ende Kontaktspitzen 40, 41 aufweist, die im Kontaktierungszustand elastisch gegen die Unterseite der Schirmplatte 17 gedrückt werden. Nach der Montage stellt der Kontaktarm 35 eine federnde elektrisch leitende Verbindung der Kontaktbrücke 24 zu der Schirmplatte 17 her und damit auch einen Kontakt zwischen der Schirmplatte und beispielsweise einem Lagerschild des Elektromotors, an der der Klemmdorn 33 befestigt ist.

An Stelle der Klemmdorne 33, 34 sind auch andere kontaktierende Befestigungsarten der Kontaktbrücke denkbar, wie beispielsweise die Befestigung mittels einer Schraube. Die Befestigung mittels Klemmdornen, auf die die Befestigungsabschnitte aufschiebbar sind, ist jedoch besonders montagefreundlich.

Es ist aus der Fig. 15 ersichtlich, dass die Klemmdorne 33, 34 an ihren freien Enden spitz zulaufen um das Einführen in die Klemmschlitze 30A, 31A zu erleichtern.

Durch die Ausgestaltung der Kontaktbrücke 24 wird eine sichere Verbindung zwischen dem Element, mit dem der erste Befestigungsabschnitt 30 verbunden ist und dem Element mit dem der zweite Befestigungsabschnitt 31 verbunden ist bzw. dem Element, an das der federnde Kontaktarm 25 gepresst ist, hergestellt, unabhängig davon, ob diese Elemente im Rahmen eines Betriebs des Motors beispielsweise vibrieren. Damit kann beispielsweise eine Massenverbindung von einem Masseelement, beispielsweise als Element einer Anschlusseinrichtung, zu einem Lagerschild sicher hergestellt werden.

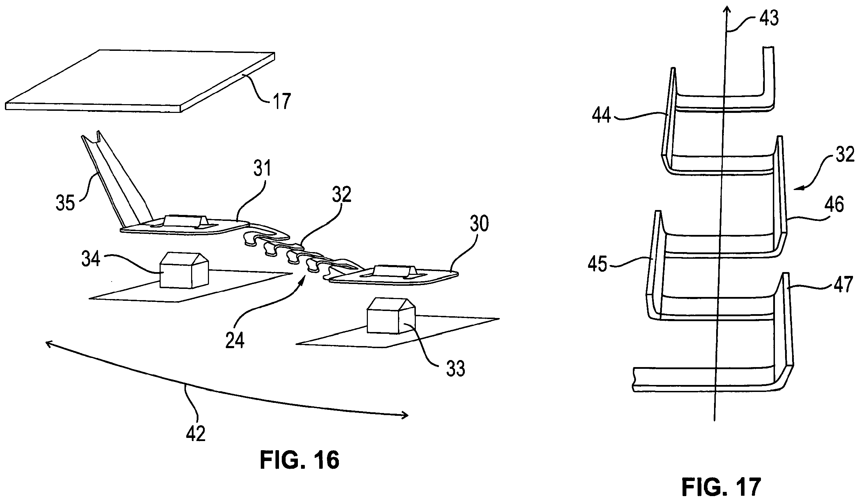

Die Fig. 16 zeigt die Kontaktbrücke 24 aus der Fig. 15 in einer perspektivisch etwas geänderten Ansicht, wobei deutlich wird, dass die Kontaktbrücke 24 aus der Blechebene leicht herausgebogen sein kann, jedoch im Wesentlichen in einer Längsrichtung verläuft, die durch den Doppelpfeil 42 angedeutet ist. der Doppelpfeil 42 ist auch in der Fig. 15 angedeutet. Die Befestigungsabschnitte 30, 31 sind gegenüber dem Brückenelement 32 leicht abgewinkelt. Es sind zudem die Klemmdorne 33, 34 dargestellt.

Fig. 17 zeigt in einer perspektivischen Ansicht das Brückenelement 32 mit mehreren mäanderförmigen Leiterwindungen mit einer Verlaufsrichtung 43 des Brückenelements 32 bzw. der Kontaktbrücke 24. Dabei ist angedeutet, dass die seitlichen, im Wesentlichen in der Verlaufsrichtung 43 des Brückenelements ausgerichteten Leiterabschnitte 44, 45, 46, 47 der mäanderförmigen Leiterführung aus der Ebene der übrigen Leiterabschnitte also der Ebene des Blechs und der Befestigungsabschnitte 30, 31 senkrecht derart herausgebogen sind, dass diese Leiterabschnitte 44, 45, 46, 47 parallel zur Verlaufsrichtung 43 und senkrecht zur Blechebene verlaufen. Die Biegekanten der genannten herausgebogenen Leiterabschnitte sind im Ausführungsbeispiel parallel zur Verlaufsrichtung 43 des Brückenelementes 32.

Dadurch wird in diesem Bereich der genannten herausgebogenen Leiterabschnitte 44, 45, 46, 47 ein seitwärtiges Krümmen des Brückenelementes 32 innerhalb der Ebene des Federblechs, die mit der Ebene der übrigen Leiterabschnitte des Brückenelementes 32 zusammenfällt, erleichtert. Insgesamt wird durch das Vorsehen dieser senkrecht aufgebogenen wangenartigen Leiterabschnitte 44, 45, 46, 47 somit die Flexibilität des Brückenelementes 32 größer.

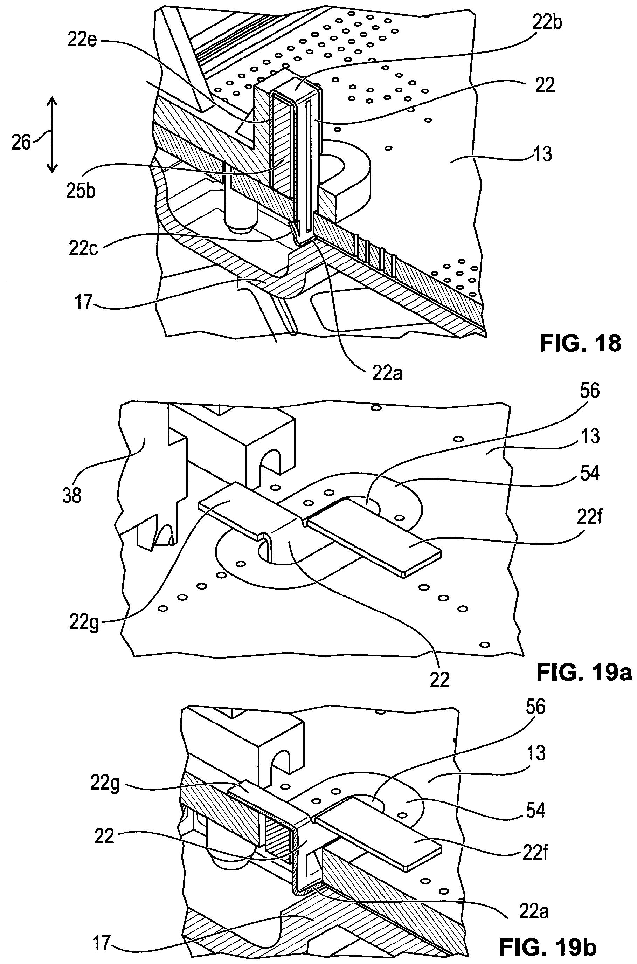

Fig. 18 zeigt eine weitere Ausgestaltung der Blechzunge 22 und der Führungsschiene 25b, entlang derer bei Montage die Blechzunge 22 in Richtung des Doppelpfeils 26 verschiebbar ist.

Die Blechzunge 22 weist an ihrem oberen Ende ein Flachstück 22b auf, das hier als rechtwinklig abgewinkeltes Ende der Blechzunge ausgeführt ist. Dieses liegt im Montagezustand auf der Führungsschiene 25b auf und geht in ein weiteres, hierzu rechtwinkliges Flachstück 22e über, sodass der Querschnitt der Blechzunge 22 im Wesentlichen U-förmig ist.

Am unteren, dem Flachstück entgegengesetzten Ende der Blechzunge 22 ist das Druckkontaktstück 22a in Form eines ebenfalls umgebogenen Endes erkennbar. Dort befindet sich die Rastnase 22c, die einen Hintergriff zu der Leiterplatte 13 bildet. Mit anderen Worten sind die Leiterplatte 13 und die Führungsschiene 25b kraftschlüssig zwischen dem Flachstück 22b und der Leiterplatte 13 eingeklemmt. Aufgrund der Verrastung ist die Blechzunge 22 vor einem Herausschieben aus der Klemmeinrichtung 25 bewahrt ist.

In Fig. 19a und b ist eine weitere Ausführung der Blechzunge 22 perspektivisch bzw. perspektivisch in einer Schnittdarstellung gezeigt. Die Blechzunge 22 ist im Vergleich zu der in Fig. 18 dargestellten Ausführungsform verkürzt ausgeführt. So fehlen die Flachstücke 22b und 22e, wohingegen die Rastnase 22c und das Druckkontaktstück 22a den entsprechenden in Fig. 18 gezeigten Bauteilen entspricht. Das dem Druckkontaktstück 22a gegenüber liegende Ende der Blechzunge 22 ist freiendseitig unter Bildung zweier Schenkel 22f, 22g eingeschnitten. Die beiden Schenkel 22f, 22g sind jeweils um 90° abgewinkelt, wobei die Richtung hierzu antiparallel ist. Mit anderen Worten ist bei einer Draufsicht auf die Leiterplatte 13 und die Blechzunge 22 der gebildete Umriss der Blechzunge 22 im Wesentlichen Z- bzw. S-förmig.

Die Schenkel 22f, 22g liegen auf einem aus einem leitenden Material hergestellten Begrenzungsring 54 auf, mittels dessen eine Umrandung eines in die Leiterplatte 13 eingebrachten Langlochs 56 gebildet ist. Dieses Langloch 56 ist mit Masse verbunden. Beispielsweise ist hierfür eine Litze an dem Begrenzungsring 54 angelötet oder eine Leiterbahn führt von dem Begrenzungsring 54 zu dem Masseelement 28.

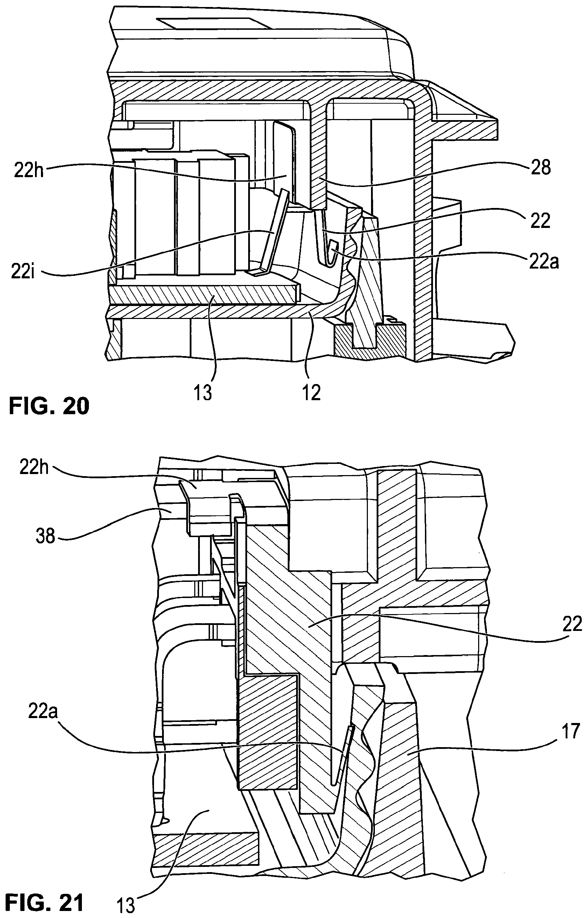

In Fig. 20 ist eine weitere Ausführungsform der Blechzunge 22 dargestellt. Diese weist eine Klammer 22h auf, die sich an dem dem Druckkontaktstück 22a gegenüber liegenden Ende befindet. Die Klammer 22h ist auf das Masseelement 28, hier in Form eines Steges eines Deckels kraftschlüssig aufgesetzt. Mit anderen Worten befindet sich der Steg des Deckels zwischen den zueinander parallelen Klemmschenkeln der Klammer 22h. Das Druckkontaktstück 22a liegt an der Schirmplatte 17 an, so dass eine elektrische Verbindung zwischen der Schirmplatte 17 und dem Masseelement 28 realisiert ist. An der Klammer 22h ist eine weitere Blechzunge 22i mit einem weiteren freiendseitigen Druckkontaktstück angeformt, das auf der Leiterplatte 13 aufliegt. Mittels dieses wird die Leiterplatte 13 stabilisiert. Ferner kann auf diese Weise die Leiterplatte 13 über die Blechzunge 22i mit dem Masseelement 28 verbunden werden.

Fig. 21 zeigt eine weitere Ausführungsform der Blechzunge 22 mit dem Druckkontaktstück 22a, das an der Schirmplatte 17 anliegt. Die Klammer 22h ist in dieser Variante an einen der Anschlussleiter 38 mittels einer kraftschlüssigen Verbindung befestigt, der das Masseelement 28 darstellt.

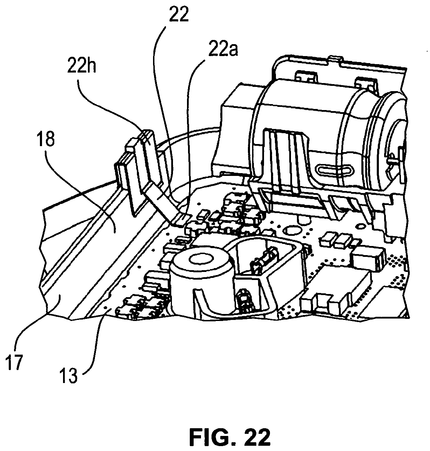

In Fig. 22 ist ausschnittsweise eine weitere Ausführungsform der Blechzunge 22 dargestellt. Die Blechzunge 22 weist wiederum die Klammer 22h auf, die in diesem Fall jedoch auf dem Rand 18 der Schirmplatte 17 aufgesetzt ist. Mit anderen Worten ist eine kraftschlüssige Verbindung zwischen der Klammer 22h und der Schirmplatte 17 erstellt. Das Druckkontaktstück 22a ist in direktem mechanischen Kontakt mit der Leiterplatte 13 und stellt auf diese Weise eine elektrische Verbindung zwischen der Leiterplatte 13 und der Schirmplatte 17 her. Unterhalb des Druckkontaktstücks 22a befindet sich eine nicht näher dargestellte Leiterbahn der Leiterplatte 13, die mit dem Masseelement 28 elektrisch verbunden ist. Auf diese Weise ist eine elektrische Verbindung zwischen der Schirmplatte 17 und dem Masseelement 28 realisiert.

Durch die geschilderten Maßnahmen und erfindungsgemäßen Merkmale wird damit insgesamt eine zuverlässige und niederohmige Verbindung der auf Massepotential zu bringenden Stator- und Rotorteile sowie der Lagerschilde eines Elektromotors zu einem Masseelement bzw. Masseanschluss verbessert, so dass insgesamt die elektromagnetische Abschirmung der signalbeaufschlagten Windungen der elektrischen Maschine verbessert und die Stabilität gegenüber Spannungsüberschlägen durch eine Masseverbindung mit geringem Widerstand und geringer Impedanz ebenfalls verbessert wird.

### Bezugszeichenliste

- 1: elektr. Maschine
- 2: Mittellinie
- 3, 3': Stator
- 4, 4': Rotor
- 5: Lagerschild
- 6, 7: Lager
- 8: Welle
- 9: Stege/Glocke
- 10: Lagerschild
- 11: Lüfterrad
- 12: Ansteuereinrichtung
- 13: Leiterplatte
- 14, 15: elektronisches Bauelemente
- 17: Schirmplatte
- 18: umgebördelter Rand
- 19: Anschlusseinrichtung
- 20: Koppelelement
- 21: Schirmkontur
- 22: Blechzunge
- 22a: Druckkontaktstück
- 22b: Flachstück
- 22c: Rastnase
- 22d: Rastöffnung
- 22e: Flachstück
- 22f,g: Schenkel
- 22h: Klammer
- 22i: Blechzunge
- 23: Öffnung
- 24: Kontaktbrücke
- 25: Klemmeinrichtung
- 25a: Führungskanal
- 25b: Führungsschiene
- 25c: Seitenwange
- 25d: Seitenwange
- 25e: Winkelstück
- 25f: Winkelstück
- 25g: Nase
- 25h: Bauteil
- 25i: Bodenplatte
- 26: Doppelpfeil
- 27: Kontaktfahne
- 28: Rahmen
- 29: Vertiefung
- 30: erster Befestigungsabschnitt
- 30a: Klemmöffnung
- 30b, 30c: Trennschlitze
- 31: zweiter Befestigungsabschnitt
- 31a: Klemmöffnung
- 32b, 32c: Trennschlitze
- 32: Brückenelement
- 32a, 32b: gekrümmte Abschnitte
- 33: erster Klemmdorn
- 34: zweiter Klemmdorn
- 35: Kontaktarm
- 36: hohlzyl. Kontaktelement
- 37, 38: Anschlussleiter
- 39: Blechzunge
- 39a: vorderer Blechstreifen
- 39b: hinterer Blechstreifen
- 39c: Rastnase
- 40, 41: Kontaktspitzen
- 42: Doppelpfeil
- 43: Verlaufsrichtung
- 44, 45, 46, 47: Abschnitte
- 50: Motorgehäuse
- 51: Verbindungsleiter
- 52a, 52b: Wicklung am Stator
- 54: Begrenzungsring
- 56: Langloch

## Patentansprüche

1. Rotierende elektrische Maschine, insbesondere Elektromotor (1), mit einer Wicklung (52a, 52b) und mit einer elektronischen Ansteuereinrichtung (12) sowie mit einer elektrisch leitenden, zwischen der Ansteuereinrichtung (12) und der Wicklung (52a, 52b) angeordneten Schirmplatte (17) und mit einer Anschlusseinrichtung (19), die wenigstens ein Koppelelement (20) zur elektrischen Verbindung der Ansteuereinrichtung (12) mit einer oder mehreren Leitungen und ein zur Verbindung mit einem elektrischen Massepotential vorgesehenes Masseelement (28) aufweist, wobei die Schirmplatte (17) elektrisch leitend mittels einer Blechzunge (22, 39) über einen ersten elektrischen Druckkontakt (22a) mit dem Masseelement (28) verbunden ist,
**dadurch gekennzeichnet,**
- **dass** die Blechzunge (22, 39) mittels eines mit dieser durch einen Druckkontakt elektrisch kontaktierten Verbindungsleiters (51) mit dem Masseelement (28) leitend verbunden ist,
- **dass** die Ansteuereinrichtung (12) eine Leiterplatte (13) mit Leiterbahnen aufweist, und
- **dass** der Verbindungsleiter (51) wenigstens einen Abschnitt einer Leiterbahn der Ansteuereinrichtung (12) umfasst.

2. Rotierende elektrische Maschine nach Anspruch 1,
**dadurch gekennzeichnet,**
- **dass** die Ansteuereinrichtung (12) eine Leiterplatte (13) mit Leiterbahnen aufweist, und
- **dass** die Blechzunge (22, 39) die Ebene der Leiterplatte (13), insbesondere eine Ausnehmung (23) in der Leiterplatte, durchsetzt und in einer Klemmeinrichtung (25) mechanisch gehalten sowie elektrisch mit dem Masseelement (28) oder mit der Schirmplatte (17) verbunden ist.

3. Rotierende elektrische Maschine nach Anspruch 2,
**dadurch gekennzeichnet,**
**dass** wenigstens ein Element (25b, 25h), insbesondere ein isolierendes Element, der Klemmeinrichtung (25) mit der Leiterplatte (13) verbunden ist.

4. Rotierende elektrische Maschine nach Anspruch 2 oder 3,
**dadurch gekennzeichnet,**
**dass** wenigstens ein Element (25b) der Klemmeinrichtung (25), insbesondere ein elektrisch leitendes Element (25b) der Klemmeinrichtung (25), steif mit dem Masseelement (28) verbunden ist.

5. Rotierende elektrische Maschine nach einem der Ansprüche 2 bis 4,
**dadurch gekennzeichnet,**
- **dass** die Blechzunge (22, 39) sich im Wesentlichen in einer Längsrichtung (26) erstreckt, und
- **dass** die Klemmeinrichtung (25) wenigstens eine Führungsschiene (25b) aufweist, in der die Blechzunge (22, 39) in deren Längsrichtung (26) verschiebbar geführt ist.

6. Rotierende elektrische Maschine nach Anspruch 5,
**dadurch gekennzeichnet,**
**dass** die Klemmeinrichtung (25) ein Gegenlager (25h) aufweist, durch das die Blechzunge (22, 39) gegen die Führungsschiene (25b) gepresst ist.

7. Rotierende elektrische Maschine nach Anspruch 6,
**dadurch gekennzeichnet,**
**dass** die Führungsschiene (25b) oder das Gegenlager (25h) mit der Blechzunge (22, 39) nach Art einer Rastverbindung zusammenwirkt.

8. Rotierende elektrische Maschine nach einem der Ansprüche 2 bis 7,
**dadurch gekennzeichnet,**
**dass** die Blechzunge (22, 39) durch ein zweites Druckkontaktstück (22e) mit einer Leiterbahn (51) der Leiterplatte (13) in einer Druckkontaktverbindung zusammenwirkt und diese mit dem Masseelement (28) elektrisch verbindet.

9. Rotierende elektrische Maschine nach einem der Ansprüche 2 bis 8,
**dadurch gekennzeichnet,**
**dass** der Stator (3, 3') und der Rotor (4, 4') zumindest teilweise auf Massepotential sind.

10. Bürstenlose rotierende elektrische Maschine nach einem der Ansprüche 1 bis 9,

11. Rotierende elektrische Maschine nach einem der Ansprüche 1-10, wobei die Ansteuereinrichtung eine Leiterplatte (13) und eine die Ebene der Leiterplatte (13) durchsetzende und in einer Klemmeinrichtung (25) gehaltene sowie mit einem Massepotential verbundene elastische Blechzunge (22, 39) aufweist, die zur Herstellung eines elektrischen Druckkontaktes mit einer der Leiterplatte (13) benachbarten elektrisch leitenden Schirmplatte (17) eingerichtet ist, wobei wenigstens ein Element (25b, 25h), insbesondere ein isolierendes Element, der Klemmeinrichtung (25) mit der Leiterplatte (13) verbunden ist.

## Claims

1. Rotary electric machine, in particular electric motor (1), having a winding (52a, 52b) and having an electronic control device (12), as well as having an electrically conductive shielding plate (17) arranged between the control device (12) and the winding (52a, 52b) and having a connection device (19), which has at least one coupling element (20) for the electrical connection of the control device (12) to one or more lines, and a mass element (28) provided for the connection to an electric mass potential, wherein the shielding plate (17) is connected to the mass element (28) in an electrically conductive manner by means of a sheet metal tongue (22, 39) via a first electric pressure contact (22a),
**characterised in that**
- the sheet metal tongue (22, 39) is conductively connected to the mass element (28) by means of a connection conductor (51) electrically contacted with said sheet metal tongue (22, 39) by way of a pressure contact,
- the control device (12) has a circuit board (13) having conductor tracks, and
- the connection conductor (51) comprises at least one portion of a conductor track of the control device (12).

2. Rotary electric machine according to claim 1,
**characterised in that**
- the control device (12) has a circuit board (13) having conductor tracks, and
- the sheet metal tongue (22, 39) penetrates the plane of the circuit board (13), in particular a recess (23) in the circuit board, and is mechanically held in a clamping device (25) and electrically connected to the mass element (28) or to the shielding plate (17).

3. Rotary electric machine according to claim 2,
**characterised in that**
the at least one element (25b, 25h), in particular an insulating element, of the clamping device (25) is connected to the circuit board (13).

4. Rotary electric machine according to claim 2 or 3,
**characterised in that**
at least one element (25b) of the clamping device (25), in particular an electrically conductive element (25b) of the clamping device (25), is rigidly connected to the mass element (28).

5. Rotary electric machine according to one of claims 2 to 4,
**characterised in that**
- the sheet metal tongue (22, 39) extends substantially in a longitudinal direction (26), and
- the clamping device (25) has at least one guiding rail (25b), in which the sheet metal tongue (22, 39) is shiftably guided in its longitudinal direction (26).

6. Rotary electric machine according to claim 5,
**characterised in that**
the clamping device (25) has a counter bearing (25h), by means of which the sheet metal tongue (22, 39) is pressed against the guiding rail (25b).

7. Rotary electric machine according to claim 6,
**characterised in that**
the guiding rail (25b) or the counter bearing (25h) cooperate with the sheet metal tongue (22, 39) in the manner of a latching connection.

8. Rotary electric machine according to one of claims 2 to 7,
**characterised in that**
the sheet metal tongue (22, 39) cooperates with a conductor track (51) of the circuit board (13) in a pressure contact connection by means of a second pressure contact piece (22e) and electrically connects said conductor track (51) to the mass element (28).

9. Rotary electric machine according to one of claims 2 to 8,
**characterised in that**
the stator (3, 3') and the rotor (4, 4') are at least partially at mass potential.

10. Brushless rotary electric machine according to one of claims 1 to 9,

11. Rotary electric machine according to one of claims 1-10, wherein the control device has a circuit board (13) and an elastic sheet metal tongue (22, 39) which penetrates the plane of the circuit board (13) and is held in a clamping device (25) and is connected to a mass potential, said sheet metal tongue (22, 39) being set up for the production of an electric pressure contact having an electrically conductive shielding plate (17) adjacent to the circuit board (13), wherein at least one element (25b, 25h), in particular an insulating element, of the clamping device (25) is connected to the circuit board (13).

## Revendications

1. Machine électrique tournante, en particulier moteur électrique (1), comprenant un enroulement (52a, 52b) et un dispositif d'excitation électronique (12), ainsi qu'une plaque de protection (17) conductrice d'électricité disposée entre le dispositif d'excitation (12) et l'enroulement (52a, 52b) et un dispositif de raccordement (19) qui est muni d'au moins un élément de couplage (20) pour la connexion électrique du dispositif d'excitation électronique (12) avec une ou plusieurs lignes et d'un élément de masse (28) prévu pour la liaison avec un potentiel de masse électrique, la plaque de protection (17) étant reliée électriquement à l'élément de masse (28) au moyen d'une languette en tôle (22, 39) par un premier contact à pression électrique (22a),
**caractérisée**
- **en ce que** la languette en tôle (22, 39) est reliée de manière conductrice à l'élément de masse (28) au moyen d'une conduite de liaison (51) qui est en contact électrique avec ladite languette par un contact en pression,
- **en ce que** le dispositif d'excitation (12) est muni d'une carte de circuit imprimé (13) avec des pistes conductrices, et
- **en ce que** la conduite de connexion (51) comprend au moins un tronçon d'une piste conductrice du dispositif d'excitation (12).

2. Machine électrique tournante selon la revendication 1,
**caractérisée**
- **en ce que** le dispositif d'excitation (12) est muni d'une carte de circuit imprimé (13) avec des pistes conductrices, et
- **en ce que** la languette en tôle (22, 39) traverse le plan de la carte de circuit imprimé (13), en particulier un évidement (23) dans la carte de circuit imprimé, et est maintenue mécaniquement dans un dispositif de serrage (25) et est reliée électriquement à l'élément de masse (28) ou à la plaque de protection (17).

3. Machine électrique tournante selon la revendication 2,
**caractérisée**
**en ce qu'**au moins un élément (25b, 25h) du dispositif de serrage (25), en particulier un élément isolant, est relié à la carte de circuit imprimé (13).

4. Machine électrique tournante selon la revendication 2 ou 3,
**caractérisée**
**en ce qu'**au moins un élément (25b) du dispositif de serrage (25), en particulier un élément électriquement conducteur (25b) du dispositif de serrage (25), est relié rigidement à l'élément de masse (28).

5. Machine électrique tournante selon l'une des revendications 2 à 4,
**caractérisée**
- **en ce que** la languette en tôle (22, 39) s'étend sensiblement dans une direction longitudinale (26), et
- **en ce que** le dispositif de serrage (25) est muni d'au moins un rail de guidage (25b) dans lequel la languette en tôle (22, 39) est guidée de manière coulissante dans sa direction longitudinale (26).

6. Machine électrique tournante selon la revendication 5,
**caractérisée**
**en ce que** le dispositif de serrage (25) est muni d'un contre-palier (25h) au moyen duquel la languette en tôle (22, 39) est pressée contre le rail de guidage (25b).

7. Machine électrique tournante selon la revendication 6,
**caractérisée**
**en ce que** le rail de guidage (25b) ou le contre-palier (25h) coopère avec la languette en tôle (22, 39) à la manière d'une liaison par encliquetage.

8. Machine électrique tournante selon l'une des revendications 2 à 7,
**caractérisée**
**en ce que** la languette en tôle (22, 39) coopère dans une connexion par contact en pression avec une piste conductrice (51) de la carte de circuit imprimé (13) par une deuxième pièce de contact en pression (22e) et relie électriquement ladite piste à l'élément de masse (28).

9. Machine électrique tournante selon l'une des revendications 2 à 8,
**caractérisée**
**en ce que** le stator (3, 3') et le rotor (4, 4') sont au moins partiellement au potentiel de masse.

10. Machine électrique tournante sans balais selon l'une des revendications 1 à 9,

11. Machine électrique tournante selon l'une des revendications 1 à 10, le dispositif d'excitation comprenant une carte de circuit imprimé (13) et une languette en tôle (22, 39) élastique qui traverse le plan de la carte de circuit imprimé (13), qui est maintenue dans un dispositif de serrage (25) et qui est reliée à un potentiel de masse et est conçue pour établir un contact électrique en pression avec une plaque de protection (17) conductrice d'électricité adjacente à la carte de circuit imprimé (13), au moins un élément (25b, 25h) du dispositif de serrage (25), en particulier un élément isolant, étant relié à la carte de circuit imprimé (13).
